# EUROPÄISCHE PATENTSCHRIFT

(11) **EP 2 954 763 B1**
(45) Veröffentlichungstag und Bekanntmachung des Hinweises auf die Patenterteilung: **04.03.2020**
(21) Anmeldenummer: 14701214.0
(22) Anmeldetag: 24.01.2014
(51) Int. Cl.: H05K 1/11, H05K 3/34, G01L 9/00, G01L 19/00

(54) **VERFAHREN ZUR VERLÖTUNG EINES ANSCHLUSSELEMENTS**
METHOD FOR SOLDERING A CONNECTION ELEMENT
PROCÉDÉ DE BRASAGE D'UN ÉLÉMENT DE CONNEXION

(30) Priorität: 11.02.2013 DE 102013101315
(43) Veröffentlichungstag der Anmeldung: 16.12.2015
(73) Patentinhaber: Endress+Hauser SE+Co. KG, 79689 Maulburg (DE)
(72) Erfinder: DREWES, Ulfert, 79379 Müllheim (DE); SCHMIDT, Elke, 79713 Bad Säckingen (DE)
(74) Vertreter: Andres, Angelika Maria
(86) Internationale Anmeldenummer: PCT/EP2014/051413
(87) Internationale Veröffentlichungsnummer: WO 2014/122033

(56) Entgegenhaltungen:
- DE-A1- 10 208 910
- DE-A1- 10 360 127
- JP-A- 2004 140 226
- JP-A- 2010 197 057
- US-B2- 8 053 685

## Beschreibung

Die Erfindung betrifft ein Verfahren zur Verlötung eines Anschlusselements an einem Anschlussort auf einer auf einer isolierenden äußeren Oberfläche eines Grundkörpers aufgebrachten elektrisch leitfähigen weichlötfähigen Beschichtung mit einem Weichlötverfahren, sowie unter Verwendung dieses Verfahrens hergestellte Sensoren.

Derartige Verfahren können insb. bei der Herstellung von Sensoren, wie zum Beispiel kapazitiven keramischen Drucksensoren, zur Herstellung elektrisch leitfähiger Verbindungen zwischen einer leitfähigen Abschirmung des Sensors oder einem Anschluss des Sensors an eine Messelektronik oder ein Bezugspotential eingesetzt werden.

Ein Beispiel für einen kapazitiven keramischen Drucksensor ist in der DE 10 2008 054 879 A1 beschrieben. Er weist einen keramischen Grundkörper, eine mit dem Grundkörper unter Bildung einer Messkammer verbundene druckempfindliche Messmembran, und einen elektromechanischen Wandler auf. Der elektromechanische Wandler wandelt eine druckabhängige Verformung der Messmembran in ein elektrisches Primärsignal um, das über durch den Grundkörper zu einer äußeren Oberfläche des Grundkörpers geführte Anschlüsse abgreifbar ist. Die Anschlüsse sind über Anschlusselemente mit einer vom Grundkörper abgesetzten Vorortelektronik verbunden, die anhand des Primärsignals ein Messsignal generiert und einer weiteren Verarbeitung, Auswertung und/oder Anzeige zur Verfügung stellt.

In der EP 1 106 982 A1 ist ein weiteres Beispiel eines keramischen Drucksensors beschrieben, dessen Grundkörper zur Abschirmung gegenüber elektromagnetischen Störsignalen mit einer leitfähigen Beschichtung versehen ist.
Die Beschichtung keramischer Grundkörper erfolgt heute vorzugsweise, indem in einem Target bereitgestellte Metalle, wie z.B. Gold oder Silber, versehen werden, auf den Grundkörper aufgesputtert werden. Alternativ werden auch metallische Lacke, wie zum Beispiel Carbon- oder Silberleitlacke, eingesetzt.

Diese Beschichtungen weisen den Nachteil auf, dass sie im Hinblick auf Weichlote regelmäßig sehr gute Benetzungseigenschaften aufweisen. Hierdurch besteht die Gefahr, dass darauf aufgebrachtes Weichlot während des Lötvorgangs unkontrolliert über die Oberfläche der Beschichtung fließt, und auch außerhalb des Anschlussorts liegende Bereiche der Oberfläche der Beschichtung benetzt.

Bei einer großflächigeren Benetzung steht für den Weichlötvorgang weniger Lot pro Flächeneinheit zur Verfügung. Um trotzdem eine qualitativ einwandfreie Lötung zu erzielen, muss Weichlot in so großer Menge zugeführt werden, dass am Anschlussort trotz des beim Löten einsetzenden Fließvorgangs immer eine ausreichende Lotmenge pro Flächeneinheit zur Verfügung steht.

Nach dem Lötvorgang erstarrt das Lot im gesamten Benetzungsgebiet. Hierdurch können auch außerhalb des Anschlussorts Unebenheiten auf der Oberfläche der Beschichtung entstehen. Die hiervon betroffenen Flächen können somit häufig nicht oder nur eingeschränkt genutzt werden. Aufgrund der Unebenheiten kann auf diesen Flächen zum Beispiel keine Sensoreinfassung, - einspannung oder -halterung abgestützt werden. Letztere werden beispielsweise für den Einbau des Sensors in einem Gehäuse, für dessen Montage am Einsatzort, oder für den Einbau in einen Prozessanschluss benötigt. Darüber hinaus müssen weitere Elemente, wie zum Beispiel eine für die Zufuhr eines Referenzdrucks im Grundkörper vorzusehende Bohrung, einen ausreichend großen Mindestabstand vom Anschlussort einhalten. Beides ist insb. in Hinblick auf eine in vielen Anwendungen gewünschte Miniaturisierung von Sensoren von Nachteil.

Zur Begrenzung der beim Weichlöten benetzten Oberfläche könnte auf die den jeweiligen Anschlussort umgebende Oberfläche der Beschichtung eine Zusatzschicht aus einem nicht benetzungsfähigen Material aufgebracht werden. Dies erfordert jedoch einen zusätzlichen Arbeitsgang.

Wo dies aufgrund der sonstigen Anforderungen an die Beschichtung möglich ist, könnte die Beschichtung in der Umgebung des jeweiligen Anschlussorts unterbrochen werden. Dies kann beispielsweise durch Aufbringung einer entsprechenden Maske während des Beschichtungsvorgangs bewirkt werden.

DE 103 60 127 A1 offenbart eine Leiterplatte, deren Anschlusspads flexibel konstruiert sind und somit die mechanischen Spannungen zwischen Bauelement und Leiterplatte nicht in die Verbindungsstelle zwischen beiden umgesetzt werden.

DE 102 08 910 A1 offenbart eine Leiterplatte, die mit einem Bauelement bestückt ist, wobei die Kontaktflächen der Leiterplatte durch Nuten voneinander getrennt sind, so dass diese ein Hindernis für den Lötwerkstoff darstellen, und so einen Kurzschluss zwischen den Kontakten des Bauelementes verhindern. DE 102 08 910 A1 offenbart nicht, dass die Nuten mit einer elektrisch leitfähigen Beschichtung beschichtet sind.

Es ist eine Aufgabe der Erfindung, ein Verfahren zur Verlötung eines Anschlusselements an einem Anschlussort auf einer elektrisch leitfähigen weichlötfähigen auf einer äußeren isolierenden Oberfläche eines Grundkörpers aufgebrachten Beschichtung mit einem Weichlötverfahren anzugeben, mit dem eine räumliche Begrenzung der beim Weichlötvorgang erfolgenden Benetzung der Beschichtung mit Weichlot bewirkt werden kann.

Hierzu umfasst die Erfindung ein Verfahren nach Anspruch 1.

Gemäß einer bevorzugten Ausgestaltung des Verfahrens umschließt die Nut den Anschlussort allseitig, insb. ringförmig.

Gemäß einer weiteren Ausgestaltung weist die Nut einen ausgeprägten Knick oder Bogen auf, über den die Position des Anschlussorts visuell erkennbar ist.

Weiter umfasst die Erfindung einen Sensor nach Anspruch 4.

Gemäß einer ersten Weiterbildung des Sensors
- ist der Anschluss ein Anschluss an eine Abschirmung des Sensors gegenüber elektromagnetischen Störungen,
- ist die Beschichtung Teil der Abschirmung, und
- bildet die Beschichtung den Anschlussbereich dieses Anschlusses.

Gemäß einer Weiterbildung des erfindungsgemäßen Sensors weist dieser mindestens einen weiteren elektrischen Anschluss auf,
- der in einen auf einer äußeren isolierenden Oberfläche des Grundkörpers befindlichen Anschlussbereich geführt ist,
- dessen Anschlussbereich mit einer auf der äußeren isolierenden Oberfläche des Grundkörpers aufgebrachten elektrisch leitfähigen weichlötfähigen Beschichtung beschichtet ist, die einen für die Kontaktierung dieses Anschlusses vorgesehenen Anschlussort umfasst,
- dessen Anschlussort zumindest teilweise außenseitlich von einer im Grundkörper vorgesehenen Nut umgeben ist, und
- an dessen Anschlussort ein Anschlusselement mittels einer Weichlotverbindung auf die Beschichtung aufgelötet ist, und
- bei dem die einzelnen auf den Grundkörper aufgebrachten Beschichtungen gegeneinander elektrisch isoliert sind.

Gemäß einer bevorzugten Ausgestaltung der Sensoren umschließt mindestens eine Nut den zugehörigen Anschlussort allseitig, insb. ringförmig.

Gemäß einer weiteren bevorzugten Ausgestaltung der Sensoren weist mindestens eine Nut einen ausgeprägten Knick oder Bogen auf, über den die Position des zugehörigen Anschlussorts visuell erkennbar ist.

Eine weitere Ausgestaltung umfasst einen Sensor, bei dem
- der Sensor ein kapazitiver Drucksensor mit einer mit dem Grundkörper unter Bildung einer Messkammer verbundenen Messmembran ist, und
- einer der Anschlüsse ein Anschluss an eine auf dem Grundkörper aufgebrachte Messelektrode ist, und/oder
- einer der Anschlüsse ein Anschluss an eine auf dem Grundkörper aufgebrachte Referenzelektrode ist, und/oder
- einer der Anschlüsse ein durch den Grundkörper geführter Anschluss an eine auf der Messmembran aufgebrachte Gegenelektrode ist.

Weiter umfasst die Erfindung einen gemäß der ersten Weiterbildung und der letztgenannten Ausgestaltung ausgebildeten Sensor, bei dem die Beschichtung des Anschlussbereichs, in den der mit der Gegenelektrode verbundene Anschluss geführt ist, zugleich die Beschichtung der Abschirmung ist, und der für die Kontaktierung des Anschlusses an die Gegenelektrode vorgesehenen Anschlussort gleich dem für die Kontaktierung der Abschirmung vorgesehenen Anschlussort ist.

Gemäß einer bevorzugten Ausgestaltung der erfindungsgemäßen Sensoren
- besteht der Grundkörper aus einer Keramik, insb. aus einer Aluminium-Oxid Keramik, und/oder
- bestehen die Beschichtungen aus Gold, aus Silber, aus Kupferlegierungen oder aus Metallschichten, insbesondere aus Nickel oder Nickellegierungen, die mit einer weichlötfähigen Deckschicht versehen sind, oder aus einem metallischen Leitlack, insb. einem Carbon- oder Silberleitlack, und/oder
- bestehen die Weichlotverbindungen aus einem Zinn-Silber Lot, einem Zinn-Kupfer Lot, oder einen Indium- und/oder Wismut-haltigen Lot, insb. ein Indium- und/oder Wismut-haltigen Zinn-Silber-Lot.

Die Erfindung und deren Vorteile werden nun anhand der Figuren der Zeichnung, in denen drei Ausführungsbeispiele dargestellt sind, näher erläutert. Gleiche Elemente sind in den Figuren mit den gleichen Bezugszeichen versehen.
- Fig. 1 zeigt:: eine Benetzung eines leitfähig beschichteten keramischen Grundkörpers mit Weichlot;
- Fig. 2 zeigt:: einen mit dem erfindungsgemäßen Verfahren hergestellten kapazitiven Drucksensor;
- Fig. 3 zeigt:: einen Anschluss eines Sensors, der an einem außerhalb seines Anschlussbereichs liegenden Anschlussort kontaktiert ist;
- Fig. 4 zeigt:: eine Explosionsdarstellung eines Drucksensors; und
- Fig. 5 zeigt:: eine Draufsicht auf eine membran-abgewandte Stirnseite des Grundkörpers des Drucksensors von Fig. 4.

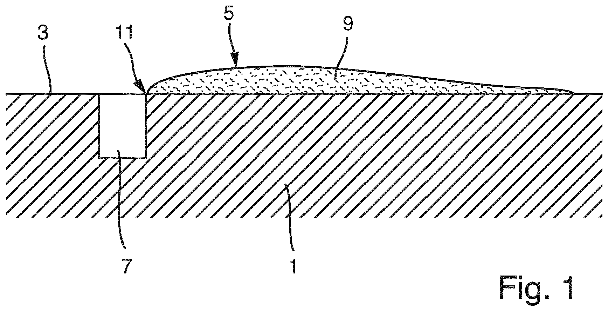

Zur Veranschaulichung der Erfindung ist in Fig. 1 ein Ausschnitt eines Grundkörpers 1 dargestellt, auf dessen äußerer isolierender Oberfläche eine elektrisch leitfähige, weichlötfähige Beschichtung 3 aufgebracht ist. Der Grundkörper 1 besteht beispielsweise insgesamt aus einem isolierenden Werkstoff, z. B. aus einer Keramik, insb. aus Aluminiumoxid, oder aus einem isolierenden Kunststoff. Alternativ kann er aber auch aus einem leitenden Werkstoff bestehen, der außenseitlich mit einer Isolationsschicht versehen ist, z.B. aus einem mit einer Isolationsschicht beschichteten Metall.

Auf der Beschichtung 3 des Grundkörpers 1 ist ein räumlich begrenzter Anschlussort 5 vorgegeben, an dem ein hier nicht dargestelltes Anschlusselement mittels einer Weichlotverbindung elektrisch leitend an die Beschichtung 3 anzuschließen ist.

Erfindungsgemäß wird hierzu in dem Grundkörper 1 eine Nut 7 vorgesehen, die den Anschlussort 5 zumindest teilweise außenseitlich umgibt. Die Nut 7 ist als zur nachfolgend zu beschichtenden Grundkörperaußenseite hin offene Ausnehmung im Grundkörper 1 ausgebildet. Sie weist im einfachsten hier dargestellten Fall die Form einer geraden Linie auf, die seitlich neben dem Anschlussort 5 verläuft. Alternativ kann die Nut 7 als den Anschlussort 5 teilweise außenseitlich umgebende gebogene Linie ausgebildet sein. Letztere kann z.B. kreis- oder ellipsensegmentförmig sein, oder einen ausgeprägten Knick in der Linienführung aufweisen. Vorzugsweise wird eine Nut 7 eingesetzt, die den Anschlussort 5 allseitig, insb. ringförmig, umschließt.

Bei keramischen Grundkörpern 1 wird die Nut 7 wird vorzugsweise unmittelbar bei deren Herstellung erzeugt. Hierzu wird der Grundkörper 1 beispielsweise aus einem Granulat gefertigt, dass in eine vorgefertigte Form eingefüllt, dort verpresst und anschließend gesintert wird. Durch entsprechende Vorgabe der Form ist die gewünschte Grundkörpergeometrie inklusive der Nut 7 mit sehr geringen Fertigungstoleranzen herstellbar, ohne dass hierzu ein zusätzlicher Fertigungsschritt erforderlich ist.

Alternativ kann die Nut 7 natürlich auch nachträglich in einem bestehenden Grundkörper 1 erzeugt werden, indem sie dort beispielsweise eingeschnitten, eingeschliffen oder eingefräst wird. Bei Grundkörpern aus leitfähigem Material wird auch die Nutoberfläche mit der Isolationsschicht versehen.

Anschließend wird zumindest ein den Anschlussort 5 einschließender Teilbereich der isolierenden äußeren Oberfläche des Grundkörpers 1 mit der Beschichtung 3 versehen.

Die Beschichtung 3 wird hierzu vorzugsweise als Metallisierung auf den Grundkörper 1 aufgesputtert. Die Metallisierung besteht vorzugsweise aus Gold, Silber, oder aus Kupferlegierungen oder aus anderen Metallschichten, insbesondere Nickel oder Nickellegierungen, die mit einer weichlötfähigen Deckschicht versehen sind.

Alternativ kann die Beschichtung 3 auch als metallischer Lack, z.B. als Carbon- oder Silberleitlack aufgebracht werden.

In einem nächsten Arbeitsgang wird Weichlot 9 lokal auf den Anschlussort 5 aufgebracht und das in Fig. 1 nicht dargestellte Anschlusselement mittels des aufgebrachten Weichlots 9 in einem Weichlötverfahren am Anschlussort 5 verlötet.

Als Weichlot 9 kann beispielsweise ein Zinn-Silber Lot, ein Zinn-Kupfer Lot, oder ein Indium- und/oder Wismut-haltiges Lot, insb. ein Indium- und/oder Wismut-haltigen Zinn-Silber-Lot, eingesetzt werden. Alternativ können auch bleihaltige Lote eingesetzt werden.

Die Weichlötung kann beispielsweise manuell oder mittels eines Lötroboters erfolgen, indem das Weichlot 9 über einen Lotdraht zugeführt wird, der am Anschlussort 5 aufgeschmolzen wird, und das Anschlusselement in das aufgeschmolzene Weichlot 9 eingesetzt wird. Bei einer manueller Lötung bietet die Nut 7 den Vorteil, dass sie zugleich als Positionierungshilfe für die Platzierung der Lötstelle am Anschlussort 5 einsetzbar ist. Insoweit bietet insb. eine Formgebung mit einem ausgeprägten, den Anschlussort 5 umgebenden Knick, Bogen oder Ring, den Vorteil, dass dieser die Position des Anschlussorts 5 auf dem Grundkörper 1 visuell erkennbar anzeigt.

Vorzugsweise wird jedoch ein Massenlötverfahren, wie z.B. das Reflowlöten eingesetzt, bei dem das Weichlot 9 vorzugsweise vorab als Lotpaste z.B. mittels eines Dispensers auf einen oder mehrere parallel zu verlötende Anschlussorte 5 auf einem oder mehreren Grundkörpern 1 aufgebracht, die entsprechende Anzahl von Anschlusselementen - soweit möglich vorzugsweise mittels eines Bestückungsautomaten - auf die entsprechenden Anschlussorte 5 aufgesetzt werden, und die Anschlusselemente anschließend in einem Reflowlötofen verlötet werden.

Fig. 1 zeigt das Benetzungsverhalten des Weichlots 9 während des Aufschmelzens. Beim Aufschmelzen zerfließt das Weichlot 9 auf der Oberfläche der Beschichtung 3, und benetzt diese. Dort, wo das Weichlot 9 die Nut 7 erreicht, ändert sich der Benetzungswinkel am Übergang 11 zur Nut 7 drastisch. Hierdurch wird die weitere Ausbreitung des Weichlots 9 gestoppt. Dieser Effekt tritt auch dann ein, wenn die Nut 7 ebenfalls mit der Beschichtung 3 versehen ist. Im dargestellten Ausführungsbeispiel ändert sich der Benetzungswinkel um 90°. Es sind jedoch auch geringere Änderungen des Benetzungswinkels ausreichend, um die weitere Ausbreitung des Weichlots 9 zu unterbinden.

Die Nut 7 bewirkt eine räumliche Begrenzung der beim Weichlötvorgang erfolgenden Benetzung der Beschichtung 3 mit Weichlot 9. Bei einer als geschlossene den Anschlussort 5 allseitig umgebenden Linie ausgebildeten Nut 7 wird damit die insgesamt benetzbare Fläche beschränkt. Dies bietet den Vorteil, dass die benötigte Lotmenge durch die Nut 7 reduziert wird. Darüber hinaus kann sie vorab genau bestimmt, und entsprechend genau dosiert aufgebracht werden. Aber auch eine den Anschlussort 5 außenseitlich nur teilweise umschließende Nut 7 bewirkt bereits eine Reduktion der benötigten Lotmenge.

Darüber bewirkt die Nut 7, dass in den vom Anschlussort 5 aus gesehen hinter der Nut 7 liegenden Bereichen der Beschichtung 3 keine Benetzung erfolgt. Diese Bereiche stehen damit für eine anderweitige Nutzung zur Verfügung.

Das erfindungsgemäße Verfahren ist insb. bei der Herstellung von Sensoren einsetzbar, die einen Grundkörper und mindestens einen in einen auf einer äußeren isolierenden Oberfläche des Grundkörpers befindlichen Anschlussbereich geführten Anschluss aufweisen. Hierbei kann es zur Kontaktierung einzelner oder alle Anschlüsse eingesetzt werden. Hierzu wird für jeden erfindungsgemäß zu kontaktierenden Anschluss eine den Anschlussbereich des jeweiligen Anschlusses umschließende und den zugehörigen Anschlussort umfassende elektrisch leitfähige weichlötfähige Beschichtung auf den Grundkörper aufgebracht. Die Kontaktierung der Anschlüsse erfolgt dann über Anschlusselemente, die auf die oben beschriebene Weise an den zugehörigen Anschlussorten mittels Weichlötung aufgelötet werden.

Auch hier besteht der Grundkörper beispielsweise aus einer Aluminiumoxid Keramik und die Beschichtungen z.B. aus aufgesputtertem Gold, Silber, aus Kupferlegierungen oder aus anderen Metallschichten, insbesondere Nickel oder Nickellegierungen, die mit einer weichlötfähigen Deckschicht versehen sind, oder einem aufgetragenen metallischen Leitlack, z.B. einem Carbon- oder Silberleitlack.

Bei entsprechender Isolierung der einzelnen Anschlüsse eines Sensors gegeneinander und gegenüber dem Grundkörper kann auch hier ein Grundkörper aus einem leitfähigen Material eingesetzt werden, dessen Oberfläche mit einer Isolationsschicht versehen ist.

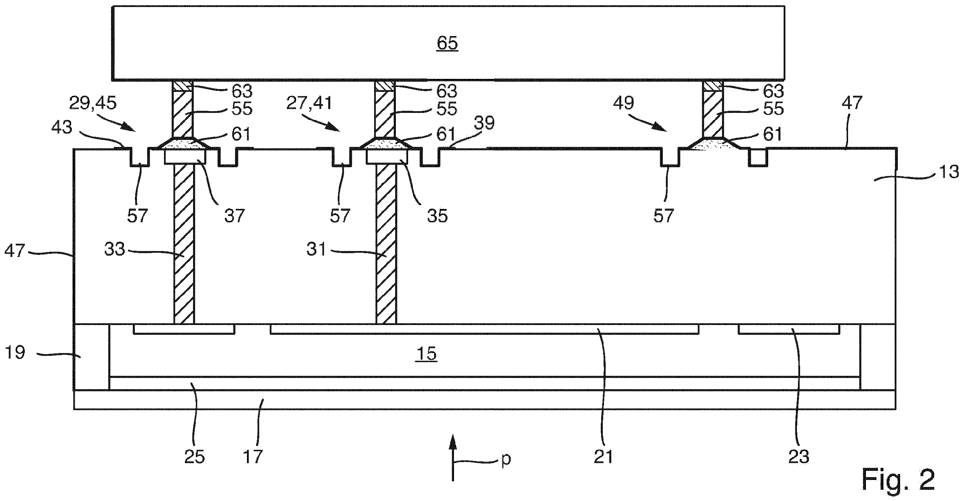

Fig. 2 zeigt als Ausführungsbeispiel hierzu einen kapazitiven keramischen Drucksensor. Der Sensor umfasst einen zylindrischen keramischen Grundkörper 13 und eine mit dem Grundkörper 13 unter Bildung einer Messkammer 15 druckdicht verbundene kreisscheibenförmige Messmembran 17. Letztere besteht z.B. aus der gleichen Keramik wie der Grundkörper 13, insb. aus Aluminiumoxid. Grundkörper 13 und Messmembran 17 sind mittels einer ringförmigen metallischen Fügung 19 von einander beabstandet miteinander verbunden.

Je nach Zielsetzung des Drucksensors herrscht in der Messkammer 15 ein anderer Gegendruck zu einem auf die Außenseite der Messmembran 17 einwirkenden Druck p. Bei einem Relativdrucksensor ist der Gegendruck der Atmosphärendruck in der Umgebung des Sensors, der über eine hier nicht dargestellte Referenzdruckzufuhr in die Messkammer 15 eingeleitet ist. Bei einem Absolutdrucksensor ist die Messkammer 15 entsprechend evakuiert.

Die Messmembran 17 ist druckempfindlich, d.h. ein auf sie einwirkender Druck p bewirkt eine Auslenkung der Messmembran 17 aus deren Ruhelage. Der Drucksensor umfasst einen elektromechanischen Wandler, der dazu dient, eine druckabhängige Verformung der Messmembran 17 in ein elektrisches Primärsignal umzuwandeln. Hierzu eignen sich beispielsweise kapazitive oder resistive Wandler. In dem dargestellten Ausführungsbeispiel eines kapazitiven Drucksensors umfasst der Wandler eine auf einer der Messmembran 17 zugewandten Seite des Grundkörpers 13 aufgebrachte kreisscheibenförmige Messelektrode 21, eine die Messelektrode 21 konzentrisch umschließende ringscheibenförmige Referenzelektrode 23 und eine auf der Innenseite der Messmembran 17 angeordnete Gegenelektrode 25. Die Messelektrode 21 und die Gegenelektrode 25 bilden einen Kondensator, dessen Kapazität sich in Abhängigkeit von der druckbedingten Auslenkung der Messmembran 17 ändert. Die Referenzelektrode 23 und die Gegenelektrode 25 bilden einen Referenzkondensator. Die Kapazität des Referenzkondensators liegt aufgrund der Position der Referenzelektrode 23 am äußeren Rand des Sensorelements, in dem die Messmembran 17 praktisch keine druckabhängige Auslenkung erfährt, konstant.

Der elektromechanische Wandler umfasst hier zwei getrennt voneinander in zugehörige in der äußeren Oberfläche des Grundkörpers 13 befindliche elektrisch voneinander getrennte Anschlussbereiche 27, 29 geführte Anschlüsse 31, 33. Der erste Anschluss 31 umfasst einen durch den Grundkörper 13 hindurch führenden metallischen Kontaktstift, der die Messelektrode 21 mit einer im zugehörigen Anschlussbereich 27 liegenden bündig mit der Oberfläche des Grundkörpers 13 abschließenden Kontaktfläche 35 verbindet. Der zweite Anschluss 33 umfasst einen durch den Grundkörper 13 hindurch führenden metallischen Kontaktstift, der die Referenzelektrode 23 mit einer im zugehörigen Anschlussbereich 29 liegenden bündig mit der Oberfläche des Grundkörpers 13 abschließenden Kontaktfläche 37 verbindet.

In dem dargestellten Ausführungsbeispiel ist eine erste elektrisch leitfähige, weichlötfähige Beschichtung 39 auf der äußeren isolierenden Oberfläche des Grundkörpers 13 aufgebracht, die den Anschlussbereich 27 des ersten Anschlusses 31 umschließt, und die einen für die Kontaktierung dieses Anschlusses 31 auf dem Grundkörper 13 vorgesehenen Anschlussort 41 umfasst. Darüber hinaus ist eine zweite elektrisch leitfähige, weichlötfähige Beschichtung 43 auf der äußeren isolierenden Oberfläche des Grundkörpers 13 aufgebracht, die den Anschlussbereich 29 des zweiten Anschlusses 33 umschließt, und die einen für die Kontaktierung dieses Anschlusses 33 auf dem Grundkörper 13 vorgesehenen zweiten Anschlussort 45 umfasst.

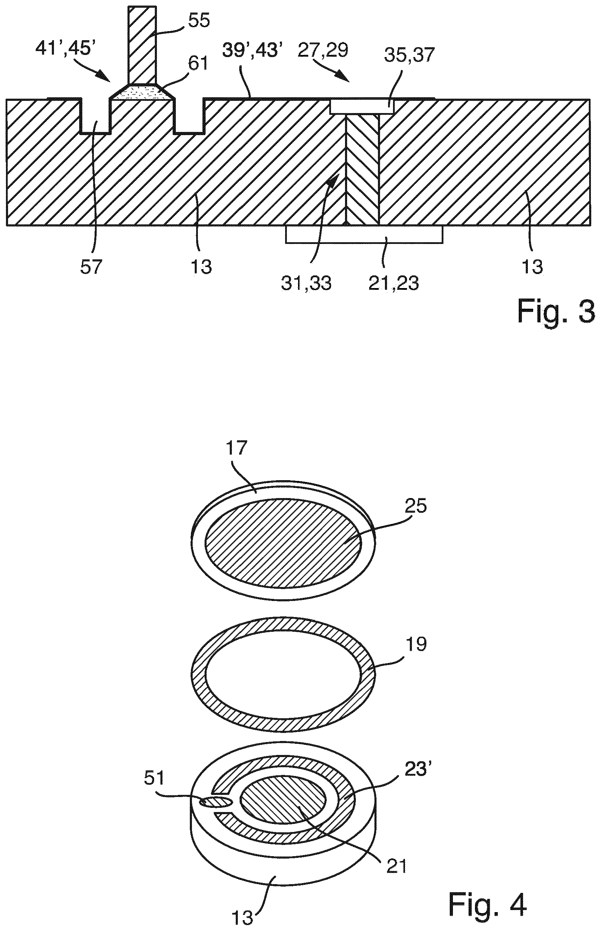

In dem in Fig. 2 dargestellten Ausführungsbeispiel liegen die Anschlussorte 41, 45 unmittelbar im jeweils zugehörigen Anschlussbereich 27, 29.
Durch entsprechende Formgebung der Beschichtungen können aber auch Anschlussorte vorgesehen werden, die außerhalb des Anschlussbereichs 27, 29 des jeweils zugehörigen Anschlusses 31, 33 liegen. Ein Beispiel hierzu ist in Fig. 3 dargestellt. Hierzu umschließt die jeweilige Beschichtung 39', 43' den jeweiligen Anschlussbereich 27, 29 des Anschlusses 31, 33 und umfasst den zugehörigen für die Kontaktierung des jeweiligen Anschlusses 31, 33 räumlich getrennt davon vorgesehenen Anschlussort 41', 45'. Entsprechend ist der Anschlussbereich 27, 29 des jeweiligen Anschlusses 31, 33 mit dem zugehörigen davon räumlich getrennt angeordneten Anschlussort 41', 45' über die zugehörige Beschichtung 39', 43' elektrisch leitend verbunden. Diese Variante der Erfindung bietet den Vorteil, dass die Anschlussorte 41', 45' unabhängig von den in der Regel durch den Sensortyp vorgegebenen Anschlussbereichen 27, 29 positioniert werden können. Hierdurch können beispielsweise räumliche Gegebenheiten beim Einbau des Sensors oder Positionen von Kontakten einer mit dem jeweiligen Anschluss zu verbindenden Elektronik berücksichtigt werden.

Um einen Kurzschluss zwischen den beiden Anschlüssen 31, 33 zu vermeiden, müssen die einzelnen Beschichtungen 39 bzw. 39' und 43 bzw. 43' elektrisch voneinander getrennt sein. Dies geschieht vorliegend, indem sie räumlich getrennt voneinander angeordnet sind, und somit durch die dazwischen liegende isolierende Oberfläche des Grundkörpers 13 elektrisch gegeneinander isoliert sind.

Der in Fig. 2 dargestellte Sensor weist eine Abschirmung gegenüber elektromagnetischen Störungen auf, wie sie beispielsweise in der EP 1 106 982 A1 beschrieben ist. Die Abschirmung umfasst eine vorzugsweise möglichst großflächig auf die äußere isolierende Oberfläche des Grundkörpers 13 aufgebrachte elektrisch leitfähige, weichlötfähige Beschichtung 47. Vorliegend überdeckt die Beschichtung 47 die freien Bereiche der membran-abgewandten Stirnfläche des Grundkörpers 13, dessen außenseitliche Mantelfläche sowie die außenseitliche Mantelfläche der Fügung 19. Sie ist über die Fügung 19 an die mit der Fügung 19 in unmittelbarem Kontakt stehende Gegenelektrode 25 angeschlossen.

Auch hier ist es natürlich zur Vermeidung von Kurzschlüssen erforderlich, dass die Beschichtung 47 der Abschirmung gegenüber allen anderen elektrischen Anschlüssen 31, 33, den jeweils zugehörigen Anschlussbereichen 27, 29, den zugehörigen Anschlussorten 41 oder 41', 45 oder 45' und den diese überdeckenden Beschichtungen 39 oder 39', 43 oder 43' elektrisch isoliert ist. Dies geschieht auch hier, indem die Beschichtung 47 der Abschirmung räumlich von diesen Elementen beabstandet ist, und somit durch die dazwischen liegende isolierende Oberfläche des Grundkörpers 13 diesen gegenüber elektrisch isoliert ist.

Auch die Abschirmung weist einen Anschluss auf, der auf einen auf der äußeren Oberfläche des Grundkörpers 13 befindlichen Anschlussbereich geführt ist. Dieser Anschluss und dessen Anschlussbereich wird vorliegend unmittelbar durch die Beschichtung 47 selbst gebildet, wobei der Anschlussbereich sich über die gesamte auf der äußeren Oberfläche des Grundkörpers 13 befindliche Fläche der Beschichtung 47 erstreckt. Dementsprechend kann ein zugehöriger Anschlussort 49, an dem die Abschirmung letztendlich kontaktiert wird, entlang der Beschichtung 47 frei vorgegeben werden.

Alternativ oder zusätzlich kann ein mit der Gegenelektrode 25 verbundener Anschluss vorgesehen sein, der durch den Grundkörper 13 hindurch in einen auf der äußeren Oberfläche des Grundkörpers 13 angeordneten mit der Beschichtung 47 beschichteten Anschlussbereich 53 geführt ist. Fig. 4 zeigt als Ausführungsbeispiel hierzu eine Explosionsdarstellung eines entsprechenden Drucksensors. Aufgrund der großen Übereinstimmung zu dem in Fig. 2 dargestellten Drucksensor werden nachfolgend lediglich die bestehenden Unterschiede näher erläutert, und im Übrigen auf die Ausführungen zu Fig. 2 verwiesen.

Der Drucksensor von Fig. 4 unterscheidet sich von dem in Fig. 2 dargestellten Drucksensor dadurch, dass die auf den Grundkörper 13 aufgebrachte Referenzelektrode 23' die Form eines nur nahezu vollständig zu einem Ring geschlossenen Ringsegments aufweist. Zwischen den beiden Enden dieses Ringsegments ist eine weitere Elektrode 51 angeordnet. Die Elektrode 51 weist vorzugsweise eine längliche Form auf, deren äußeres Ende im zusammengebauten Sensor mit der metallischen Fügung 19 in Kontakt steht, und deren inneres Ende sich zur Sensormitte hin in Richtung der Messmembran 21 erstreckt. Genau wie bei den Anschlüssen 31, 33 für die Messelektrode 21 und die Referenzelektrode 23 weist auch der Anschluss an die Gegenelektrode 25 einen durch den Grundkörper 13 hindurch führenden - in der Explosionsdarstellung nicht sichtbaren - metallischen Kontaktstift auf, über den die über die Fügung 19 mit der Gegenelektrode 25 verbundene weitere Elektrode 51 mit dem zugehörigen Anschlussbereich 53 auf der gegenüberliegenden äußeren Oberfläche des Grundkörpers 13 verbunden ist.

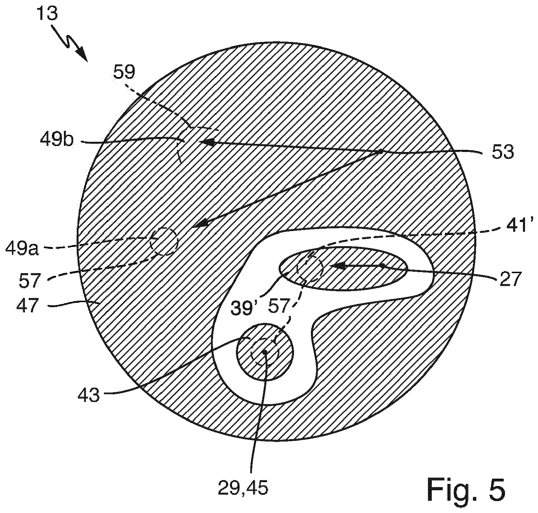

Fig. 5 zeigt eine Draufsicht auf die membran-abgewandte Stirnseite des Grundkörpers 13 des Drucksensors von Fig. 4. Dort ist der Anschlussbereich 53, in den der mit der weiteren Elektrode 51 verbundene Kontaktstift führt, schematisch durch einen Punkt angezeigt. Die Draufsicht zeigt darüber hinaus ein Ausführungsbeispiel für die Formgebung der Beschichtung 47 der Abschirmung, der den Anschlussbereich 27 und den Anschlussort 41' des mit der Messelektrode 21 verbundenen Anschlusses 31 überdeckenden Beschichtung 39', und der den Anschlussbereich 29 und den Anschlussort 45 des mit der Referenzelektrode 23' verbundenen Anschlusses 33 überdeckenden Beschichtung 43. In diesem Ausführungsbeispiel liegt der dem Anschluss 31 an die Messelektrode 21 zugeordnete Anschlussort 41' - wie auch in dem Ausführungsbeispiel von Fig. 3 gezeigt, und in Fig. 5 durch einen Pfeil verdeutlicht - außerhalb des zugehörigen Anschlussbereichs 27, und ist mit diesem über die Beschichtung 39' leitfähig verbunden. Der dem Anschluss 33 an die Referenzelektrode 23' zugeordnete Anschlussort 45 liegt - wie auch in dem Ausführungsbeispiel von Fig. 2 gezeigt - im zugehörigen Anschlussbereich 29, so dass die Beschichtung 43 Anschlussbereich 29 und Anschlussort 45 gleichermaßen überdeckt.

Da der Anschlussort 49, an dem die Abschirmung letztendlich kontaktiert wird, entlang der Beschichtung 47 frei vorgegeben werden kann, sind hierfür parallel zwei vom Anschlussbereich 53 der Abschirmung beabstandete mögliche Anschlussorte 49a, 49b eingezeichnet, die alternativ oder parallel zueinander für die Kontaktierung der Abschirmung genutzt werden können. Die Beabstandung vom zugehörigen Anschlussbereich 53 ist jeweils durch Pfeile angezeigt. Eine parallele Nutzung von zwei Anschlussorten ist z.B. sinnvoll, wenn die Abschirmung über die Beschichtung 47 an ein Bezugspotential, wie z.B. Masse, angeschlossen wird, das über die Beschichtung 47 zugleich einer Vorortelektronik als Referenzpotential zur Verfügung gestellt wird.

Erfindungsgemäß ist mindestens einer der Anschlüsse 31, 33 und/oder der Anschluss an die Abschirmung unter Einsatz des oben beschriebenen Verfahrens mittels einer am zugehörigen Anschlussort 41 bzw. 41', 45 bzw. 45', 49, 49a, 49b erzeugten Weichlotverbindung an ein Anschlusselement 55 angeschlossen. Als Anschlusselemente 55 können beispielsweise die in Fig. 2 dargestellten metallischen Anschlussstifte eingesetzt werden. Alternativ können aber auch Anschlussdrähte, oder - vorzugsweise SMD-lötfähige-Kontakte, insb. Kontakte einer Vorortelektronik, eingesetzt und auf die entsprechenden Anschlussorte aufgelötet werden.

Hierzu ist im Grundkörper 13 des Sensors für jeden dieser erfindungsgemäß zu kontaktierenden Anschlüsse 31, 33 jeweils eine Nut 57, 59 vorgesehen, die den diesem Anschluss 31, 33 zugeordneten beschichteten Anschlussort 41, 41', 45, 45', 49, 49a, 49b zumindest teilweise außenseitlich umgibt.

Bezüglich der Formgebung dieser Nuten 57, 59 gelten die obigen Ausführungen zur Nut 7. Bis auf die den Anschlussort 49b des Anschlusses der Abschirmung nur teilweise umgebende Nut 59 sind alle übrigen in den Figuren 2, 3 und 5 dargestellten Nuten 57 als den jeweiligen Anschlussort 41, 41', 45, 45', 49, 49a allseitig ringförmig umgebende Nuten 57 ausgebildet.

Auch bei der Herstellung der erfindungsgemäßen Sensoren, werden die Nuten 57, 59 auf die eingangs beschriebene Weise erzeugt. Anschließend werden die Beschichtungen 39 oder 39', 43 oder 43', 47 aufgebracht. Dabei werden zumindest diejenigen Nutbereiche der Nuten 57, 59 beschichtet, die in Bereichen verlaufen, über die einer der Anschlussbereiche 27, 29, 53 über die zugehörige Beschichtung 39', 43', 47 mit dem entfernt davon angeordneten zugehörigen Anschlussort 41', 45', 49a elektrisch leitend zu verbinden ist. In dem in Fig. 5 dargestellten Ausführungsbeispiel überdeckt die Beschichtung 39' also zumindest einen Teilbereich der den Anschlussort 41' des Anschlusses 31 an die Messelektrode 21 umgebenden ringförmigen Nut 57, und die Beschichtung 47 überdeckt zumindest einen Teilbereich der den Anschlussort 49a des Anschlusses an die Abschirmung umgebenden ringförmigen Nut 57.

Alle übrigen Nutbereiche müssen nicht zwingend beschichtet werden, können dies aber, soweit es z.B. aus Gründen der Herstellungstoleranzen bei der Aufbringung der jeweiligen Beschichtung, oder aus anderen, insb. durch die elektrischen Eigenschaften der jeweiligen Beschichtung, gegebenen Gründen sinnvoll ist. In dem in Fig. 5 dargestellten Ausführungsbeispiel sind alle Nuten 57, 59 vollständig beschichtet.

Anschließend werden die Anschlusselemente 55 durch Zufuhr oder Aufbringung von Weichlot und anschließende Verlötung auf die oben beschriebene Weise auf die zugehörigen Anschlussorte 41 bzw. 41', 45 bzw. 45', 49, 49a, 49b aufgelötet. Fig. 2 zeigt hierzu drei mit dem erfindungsgemäßen Verfahren erzeugte Weichlotverbindungen 61, über die der Anschluss 31 an die Messelektrode 21, der Anschluss 33 an die Referenzelektrode 23 und der Anschluss der Abschirmung jeweils mit dem zugehörigen Anschlusselement 55 verbunden sind. Die Weichlotverbindungen 61 bestehen auch hier beispielsweise aus einem Zinn-Silber Lot, einem Zinn-Kupfer Lot, oder einen Indium- und/oder Wismut-haltigen Lot, insb. ein Indium- und/oder Wismut-haltigen Zinn-Silber-Lot. Alternativ können auch hier bleihaltige Weichlote eingesetzt werden.

Über die Anschlusselemente 55 wird hier, insb. über einen weiteren Lötvorgang, sowohl eine elektrische Verbindung der drei Anschlüsse 31, 33 mit entsprechenden Kontakten 63 einer Vorortelektronik 65 hergestellt, als auch die Vorortelektronik 65 in einer vom Grundkörper 13 beabstandeten Position mechanisch befestigt.
- 1: Grundkörper
- 3: Beschichtung
- 5: Anschlussort
- 7: Nut
- 9: Weichlot
- 11: Übergang zur Nut
- 13: Grundkörper
- 15: Messkammer
- 17: Messmembran
- 19: metallische Fügung
- 21: Messelektrode
- 23, 23': Referenzelektrode
- 25: Gegenelektrode
- 27: Anschlussbereich
- 29: Anschlussbereich
- 31: Anschluss
- 33: Anschluss
- 35: Kontaktfläche
- 37: Kontaktfläche
- 39, 39': Beschichtung
- 41, 41': Anschlussort
- 43, 43': Beschichtung
- 45, 45': Anschlussort
- 47: Beschichtung
- 49, 49a, 49b: Anschlussort
- 51: weitere Elektrode
- 53: Anschlussbereich
- 55: Anschlusselement
- 57: Nut
- 59: Nut
- 61: Weichlotverbindung
- 63: Kontakt
- 65: Vorortelektronik

## Patentansprüche

1. Verfahren zur Verlötung eines Anschlusselements (55) an einem Anschlussort (41', 45', 49a, 49b) auf einer elektrisch leitfähigen, weichlötfähigen, auf einer äußeren isolierenden Oberfläche eines Grundkörpers (1, 13) eines Sensors aufgebrachten Beschichtung (39', 43', 47), bei dem
- in dem Grundkörper (1, 13) eine Nut (57, 59) vorgesehen wird, die den Anschlussort (41', 45', 49a, 49b) zumindest teilweise derartig außenseitlich umgibt, dass sie eine räumliche Begrenzung bei einer in einem Weichlötvorgang erfolgenden Benetzung mit einem Weichlot (9) bewirkt,
- zumindest eine den Anschlussort (41', 45', 49a, 49b) umfassende Teilfläche der äußeren isolierenden Oberfläche des Grundkörpers (1, 13) mit der Beschichtung (39', 43', 47) beschichtet wird,
- das Weichlot (9) lokal auf den Anschlussort (41', 45', 49a, 49b) aufgebracht wird und die Benetzung des Anschlussortes (41', 45', 49a, 49b) mit dem Weichlot räumlich durch die Nut (57,59) begrenzt wird, und
- das Anschlusselement (55) mittels des aufgebrachten Weichlots (9) in einem Weichlötverfahren am Anschlussort (41', 45', 49a, 49b) verlötet wird,
wobei in dem Verfahren der Anschlussort (41', 45', 49a, 49b) über die zugehörige Beschichtung (39', 43', 47) mit einem auf der äußeren isolierenden Oberfläche des Grundkörpers (1,13) befindlichen davon beabstandeten Anschlussbereich (27, 29, 53) eines Anschlusses (31, 33) verbunden wird, indem die Beschichtung (39', 43', 47) derart aufgebracht wird, dass sie den Anschlussbereich (27, 29, 53) umschließt, und mit dem Anschlussort (41', 45', 49a, 49b) leitend verbindet,
und wobei zumindest diejenigen Nutbereiche der Nut (57, 59) mit der zugehörigen Beschichtung (39', 43', 47) beschichtet werden, die in Bereichen verlaufen, über die der Anschlussbereich (27, 29, 53) über die jeweilige Beschichtung (39', 43', 47) mit dem entfernt davon angeordneten zugehörigen Anschlussort (41', 45', 49a, 49b) elektrisch leitend verbunden werden.

2. Verfahren nach Anspruch 1, bei dem die Nut (57) den Anschlussort (41', 45', 49a) allseitig, insb. ringförmig, umschließt.

3. Verfahren nach Anspruch 1, bei dem die Nut (59) einen ausgeprägten Knick oder Bogen aufweist, über den die Position des Anschlussorts (49b) visuell erkennbar ist.

4. Sensor mit
- einem Grundkörper (13),
- einem elektrischen Anschluss (31, 33),
-- der in einen auf einer äußeren isolierenden Oberfläche des Grundkörpers (13) befindlichen Anschlussbereich (27, 29, 53) geführt ist,
- einer auf der äußeren isolierenden Oberfläche des Grundkörpers (13) aufgebrachten elektrisch leitfähigen, weichlötfähigen Beschichtung (39', 43', 47)
-- die den Anschlussbereich (27, 29, 53) des Anschlusses (31, 33) umschließt, und
-- die einen für die Kontaktierung dieses Anschlusses (31, 33) vorgesehenen Anschlussort (41', 45', 49a, 49b) umfasst,
- einer im Grundkörper (13) vorgesehenen Nut (57, 59), die den Anschlussort (41', 45', 49a, 49b) zumindest teilweise derartig außenseitlich umgibt, dass sie eine räumliche Begrenzung bei einer in einem Weichlötvorgang erfolgenden Benetzung mit einer Weichlotverbindung (61) bewirkt, und
- einem am Anschlussort (41', 45', 49a, 49b) mittels der Weichlotverbindung (61) auf die Beschichtung (39', 43', 47) aufgelöteten Anschlusselement (55),
wobei der Anschlussort (41', 45', 49a, 49b) außerhalb des Anschlussbereichs (27, 29, 53) des zugehörigen Anschlusses (31, 33) liegt, und über die zugehörige Beschichtung (39', 43', 47), die diesen Anschlussort (41', 45', 49a, 49b) umfasst und den zugehörigen Anschlussbereich (27, 29, 53) umschließt, elektrisch leitend mit dem Anschlussbereich (27, 29, 53) des zugehörigen Anschlusses (31, 33) verbunden ist,
und wobei zumindest diejenigen Nutbereiche der Nut (57, 59) mit der zugehörigen Beschichtung (39', 43', 47) beschichtet sind, die in Bereichen verlaufen, über die der Anschlussbereich (27, 29, 53) über die jeweilige Beschichtung (39', 43', 47) mit dem entfernt davon angeordneten zugehörigen Anschlussort (41', 45', 49a, 49b) elektrisch leitend verbunden ist.

5. Sensor gemäß Anspruch 4, bei dem
- der Anschluss (31,33) ein Anschluss an eine Abschirmung des Sensors gegenüber elektromagnetischen Störungen ist,
- die Beschichtung (47) Teil der Abschirmung ist, und
- die Beschichtung (47) den Anschlussbereich dieses Anschlusses bildet.

6. Sensor gemäß Anspruch 4 oder 5, mit mindestens einem weiteren elektrischen Anschluss (31, 33),
- der in einen auf einer äußeren isolierenden Oberfläche des Grundkörpers (13) befindlichen Anschlussbereich (27, 29, 53) geführt ist,
- dessen Anschlussbereich (27, 29, 53) mit einer auf der äußeren isolierenden Oberfläche des Grundkörpers (13) aufgebrachten elektrisch leitfähigen weichlötfähigen Beschichtung (39', 43', 47) beschichtet ist, die einen für die Kontaktierung dieses Anschlusses (31, 33) vorgesehenen Anschlussort (41', 45', 49a, 49b) umfasst,
- dessen Anschlussort (41', 45', 49a, 49b) zumindest teilweise außenseitlich von einer im Grundkörper (13) vorgesehenen Nut (57, 59) umgeben ist, und
- an dessen Anschlussort (41', 45', 49a, 49b) ein Anschlusselement (55) mittels einer Weichlotverbindung (61) auf die Beschichtung (39', 43', 47) aufgelötet ist, und
- bei dem die einzelnen auf den Grundkörper (13) aufgebrachten Beschichtungen (39', 43', 47') gegeneinander elektrisch isoliert sind.

7. Sensor gemäß einem der Ansprüche 4 bis 6,
mit einem elektrischen Anschluss (31, 33),
-- der in einen auf einer äußeren isolierenden Oberfläche des Grundkörpers (13) befindlichen Anschlussbereich (27, 29) geführt ist,
- einer auf der äußeren isolierenden Oberfläche des Grundkörpers (13) aufgebrachten elektrisch leitfähigen, weichlötfähigen Beschichtung (39, 43, 47)
-- die den Anschlussbereich (27, 29) des Anschlusses (31, 33) umschließt, und
-- die einen für die Kontaktierung dieses Anschlusses (31, 33) vorgesehenen weiteren Anschlussort (41, 45) umfasst, der im Anschlussbereich (27, 29) des zugehörigen Anschlusses (31, 33) angeordnet ist, und
--mit einer im Grundkörper (13) vorgesehenen Nut (57), die den weiteren Anschlussort (41, 45) zumindest teilweise derartig außenseitlich umgibt, dass sie eine räumliche Begrenzung bei einer in einem Weichlötvorgang erfolgenden Benetzung mit einer Weichlotverbindung (61) bewirkt, und einem am weiteren Anschlussort (41,45) mittels der Weichlotverbindung (61) auf die Beschichtung (39, 43, 47) aufgelöteten Anschlusselement (55).

8. Sensor gemäß einem der Ansprüche 4 bis 7, bei dem mindestens eine Nut (57) den zugehörigen Anschlussort (41', 45', 49a) und/oder den weiteren Anschlussort (41,45) allseitig, insb. ringförmig, umschließt.

9. Sensor gemäß einem der Ansprüche 4 bis 7, bei dem mindestens eine Nut (59) einen ausgeprägten Knick oder Bogen aufweist, über den die Position des zugehörigen Anschlussorts (49b) visuell erkennbar ist.

10. Sensor gemäß einem der Ansprüche 4 bis 9, bei dem
- der Sensor ein kapazitiver Drucksensor mit einer mit dem Grundkörper (13) unter Bildung einer Messkammer (15) verbundenen Messmembran (17) ist, und
- einer der Anschlüsse (31) ein Anschluss an eine auf dem Grundkörper (13) aufgebrachte Messelektrode (21) ist, und/oder
- einer der Anschlüsse (33) ein Anschluss (33) an eine auf dem Grundkörper (13) aufgebrachte Referenzelektrode (23, 23') ist, und/oder
- einer der Anschlüsse ein durch den Grundkörper (13) geführter Anschluss an eine auf der Messmembran (17) aufgebrachte Gegenelektrode (25) ist.

11. Sensor gemäß Anspruch 5 und 10, bei dem die Beschichtung (47) des Anschlussbereichs (53), in den der mit der Gegenelektrode (25) verbundene Anschluss geführt ist, zugleich die Beschichtung (47) der Abschirmung ist, und der für die Kontaktierung des Anschlusses an die Gegenelektrode (25) vorgesehenen Anschlussort (49a, 49b) gleich dem für die Kontaktierung der Abschirmung vorgesehenen Anschlussort (49a, 49b) ist.

12. Sensor gemäß einem der Ansprüche 4 bis 11, bei dem
- der Grundkörper (13) aus einer Keramik, insb. aus einer Aluminium-Oxid Keramik, besteht, und/oder
- die Beschichtungen (39, 39', 43, 43', 47) aus Gold, aus Silber, aus Kupferlegierungen oder aus Metallschichten, insbesondere aus Nickel oder Nickellegierungen, die mit einer weichlötfähigen Deckschicht versehen sind, oder aus einem metallischen Leitlack, insb. einem Carbon- oder Silberleitlack, bestehen, und/oder
- die Weichlotverbindungen (61) aus einem Zinn-Silber Lot, einem Zinn-Kupfer Lot, oder einen Indium- und/oder Wismut-haltigen Lot, insb. ein Indium- und/oder Wismut-haltigen Zinn-Silber-Lot, bestehen.

## Claims

1. Method for soldering a connection element (55) at a connection point (41', 45', 49a, 49b) on an electrically conductive coating (39', 43', 47), which can be soft soldered and is applied on an outer isolating surface of a meter body (1, 13) of a sensor, wherein
- a groove (57, 59) is provided in the meter body (1, 13), said groove at least partially externally surrounding the connection point (41', 45', 49a, 49b) in such a way that it creates a spatial boundary during a process of wetting with a soft solder (9) which occurs in a soft soldering process,
- at least a partial surface - encompassing the connection point (41', 45', 49a, 49b) - of the outer isolating surface of the meter body (1, 13) is coated with the coating (39', 43', 47),
- the soft solder (9) is applied locally at the connection point (41', 45', 49a, 49b) and the wetting of the connection point (41', 45', 49a, 49b) with the soft solder is limited spatially by the groove (57, 59), and
- the connection element (55) is soldered at the connection point (41', 45', 49a, 49b) in a soft soldering process using the soft solder (9) applied,
wherein, in said method, the connection point (41', 45', 49a, 49b) is connected, by means of the corresponding coating (39', 43', 47), with a connection area (27, 29, 53) of a connection (31, 33) - being located on the outer isolating surface of the meter body (1, 13) at a distance from the connection point - such that the coating (39', 43', 47) is applied in such a way that it surrounds the connection area (27, 29, 53), and is connected with the connection point (41', 45', 49a, 49b) via a conductive connection,
and wherein at least those groove areas of the groove (57, 59) are coated with the corresponding coating (39', 43', 47) that extend into areas via which the connection area (27, 29, 53) is connected in an electrically conductive manner to the associated connection point (41', 45', 49a, 49b), which is arranged at a distance therefrom, by means of the coating (39', 43', 47).

2. Method as claimed in Claim 1, wherein the groove (57) surrounds the connection point (41', 45', 49a) on all sides, partially in an annular manner.

3. Method as claimed in Claim 1, wherein the groove (59) has a pronounced curve or bend via which the position of the connection point (49b) is visually recognizable.

4. Sensor with
- a meter body (13),
- an electrical connection (31, 33),
-- said electrical connection being routed into a connection area (27, 29, 53) located on an outer isolating surface of the meter body (13),
- an electrically conductive coating (39', 43', 47), which can soft-soldered, applied on an outer isolating surface of the meter body (13),
-- said coating surrounding the connection area (27, 29, 53) of the connection (31, 33), and
-- which encompasses a connection point (41', 45', 49a, 49b) provided for the contacting of this connection (31, 33),
- a groove (57, 59) provided in the meter body (13), said groove at least partially surrounding the connection point (41', 45', 49a, 49b) externally in such a way that it creates a spatial boundary during a process of wetting with a soft solder connection (61) which occurs in a soft soldering process, and
- a connection element (55) soldered onto the coating (39', 43', 47) at the connection point (41', 45', 49a, 49b) by means of the soft solder connection (61), wherein the connection point (41', 45', 49a, 49b) is located outside the connection area (27, 29, 53) of the corresponding connection (31, 33), and is connected in an electrically conductive manner with the connection area (27, 29, 53) of the corresponding connection (31, 33) by means of the coating (39', 43', 47) which encompasses this connection point (41', 45', 49a, 49b) and surrounds the associated connection area (27, 29, 53),
and wherein at least those groove areas of the groove (57, 59) are coated with the corresponding coating (39', 43', 47) that extend into areas via which the connection area (27, 29, 53) is connected in an electrically conductive manner to the connection point (41', 45', 49a, 49b), which is arranged at a distance therefrom, by means of the coating (39', 43', 47).

5. Sensor as claimed in Claim 4, wherein
- the connection (31, 33) is a connection to a shield of the sensor against electromagnetic interference,
- the coating (47) is part of the shield, and
- the coating (47) forms the connection area of this connection.

6. Sensor as claimed in Claim 4 or 5, with at least one additional electrical connection (31, 33),
- wherein said connection is routed into a connection area (27, 29, 53) located on an outer isolating surface of the meter body (13),
- wherein said connection area (27, 29, 53) is coated with an electrically conductive coating (39', 43', 47) which can be soft soldered and is applied on the outer isolating surface of the meter body (13), said coating comprising a connection point (41', 45', 49a, 49b) provided for the contacting of this connection (31, 33),
- wherein the connection point (41', 45', 49a, 49b) is at least partially surrounded on the outside by a groove (57, 59) provided in the meter body (13), and
- wherein at said connection point (41', 45', 49a, 49b) a connection element (55) is soldered onto the coating (39', 43', 47) by means of a soft solder connection (61), and
- wherein the individual coatings (39', 43', 47) applied on the meter body (13) are electrically isolated from one another.

7. Sensor as claimed in one of the Claims 4 to 6,
with an electrical connection (31, 33),
-- wherein said connection is routed into a connection area (27, 29) located on an outer isolating surface of the meter body (13),
- an electrically conductive coating (39, 43, 47) which can be soft-soldered and is applied on the outer isolating surface of the meter body (13),
-- which surrounds the connection area (27, 29) of the connection (31, 33), and
-- which comprises an additional connection point (41, 45) provided for the contacting of this connection (31, 33), said additional connection point being arranged in the connection area (27, 29) of the associated connection (31, 33), and
-- with a groove (57) provided in the meter body (13), which at least partially surrounds the additional connection point (41, 45) externally in such a way that it creates a spatial boundary during a process of wetting with a soft solder connection (61) which occurs in a soft soldering process, and with a connection element (55) soldered onto the coating (39, 43, 47) at the additional connection point (41, 45) by means of the soft solder connection (61).

8. Sensor as claimed in one of the Claims 4 to 7, wherein at least one groove (57) surrounds the associated connection point (41', 45', 49a) and/or the additional connection point (41, 45) on all sides, partially in an annular manner.

9. Sensor as claimed in one of the Claims 4 to 7, wherein at least one groove (59) has a pronounced bend or curve via which the position of the connection point (49b) is visually recognizable.

10. Sensor as claimed in one of the Claims 4 to 9, wherein
- the sensor is a capacitance pressure sensor with a measuring diaphragm (17) connected to the meter body (13) and forming a measuring chamber (15), and
- one of the connections (31) is a connection to a measuring electrode (21) fitted on the meter body (13), and/or
- one of the connections (33) is a connection (33) to a reference electrode (23, 23') fitted on the meter body (13), and/or
- one of the connections is a connection routed through the meter body (13) to a counterelectrode (25) fitted on the measuring diaphragm (17).

11. Sensor as claimed in Claim 5 and 10, wherein the coating (47) of the connection area (53) into which the connection connected to the counterelectrode (25) is routed is simultaneously the coating (47) of the shielding, and the connection point (49a, 49b) provided for the contacting of the connection to the counterelectrode (25) is the same as the connection point (49a, 49b) provided for the contacting of the shielding.

12. Sensor as claimed in one of the Claims 4 to 11, wherein
- the meter body (13) is made from a ceramic, particularly an aluminum oxide ceramic, and/or
- the coatings (39, 39', 43, 43', 47) are made from gold, silver, copper alloys or metal layers, particularly nickel or nickel alloys, which are provided with a cover layer that can be soft-soldered, or from a metal conductive varnish, particularly a carbon or silver conductive varnish, and/or
- the soft solder connections (61) are made from a tin/silver solder, a tin/copper solder or a solder containing indium and/or bismuth, particularly a tin/silver solder containing indium and/or bismuth.

## Revendications

1. Procédé destiné au brasage d'un élément de raccordement (55) sur un lieu de raccordement (41', 45', 49a, 49b) sur un revêtement (39', 43', 47) électroconducteur, apte au brasage tendre, appliqué sur une surface extérieure isolante d'un corps de base (1, 13) d'un capteur, procédé pour lequel
- est prévue, dans le corps de base (1, 13), une rainure (57, 59), qui entoure au moins partiellement, à l'extérieur, le lieu de raccordement (41', 45', 49a, 49b), de telle sorte à ce qu'elle crée une limitation dans l'espace lors d'un mouillage réalisé dans un processus de brasage tendre à l'aide d'une brasure tendre (9),
- au moins une surface partielle - entourant le lieu de raccordement (41', 45', 49a, 49b) - de la surface isolante extérieure du corps de base (1, 13) est revêtue par un revêtement (39', 43', 47),
- la brasure tendre (9) est appliquée localement sur le lieu de raccordement (41', 45', 49a, 49b) et le mouillage du lieu de raccordement (41', 45', 49a, 49b) avec la brasure tendre est limité dans l'espace par la rainure (57, 59), et
- l'élément de raccordement (55) est brasé au moyen de la brasure tendre (9) appliquée dans un procédé de brasage tendre sur le lieu de raccordement (41', 45', 49a, 49b),
procédé pour lequel le lieu de raccordement (41', 45', 49a, 49b) est relié, par le biais du revêtement (39', 43', 47) correspondant, avec une zone de raccordement (27, 29, 53) - se trouvant sur la surface isolante extérieure du corps de base (1, 13) - d'une connexion (31, 33), en ce que le revêtement (39', 43', 47) est appliqué de telle sorte qu'il entoure la zone de raccordement (27, 29, 53) et est relié au lieu de raccordement (41', 45', 49a, 49b) via une liaison conductrice,
et procédé pour lequel au moins les zones de la rainure (57, 59), qui sont revêtues avec le revêtement (39', 43', 47) correspondant et qui s'étendent dans des zones par l'intermédiaire desquelles la zone de raccordement (27, 29, 53) est reliée - via une liaison électroconductrice, par le biais du revêtement (39', 43', 47) respectif - avec le lieu de raccordement (41', 45', 49a, 49b) disposé à distance de celle-ci.

2. Procédé selon la revendication 1, pour lequel la rainure (57) entoure de tous côtés, notamment sous forme annulaire, le lieu de raccordement (41', 45', 49a).

3. Procédé selon la revendication 1, pour lequel la rainure (59) présente une brisure ou une courbure, par l'intermédiaire de laquelle la position du lieu de raccordement (49b) est reconnaissable visuellement.

4. Capteur avec
- un corps de base (13),
- une connexion électrique (31, 33),
-- laquelle connexion est acheminée dans une zone de raccordement (27, 29, 53) se trouvant sur une surface isolante extérieure du corps de base (13),
- un revêtement (39', 43', 47) apte au brasage tendre, électroconducteur, appliqué sur une surface isolante extérieure du corps de base (13),
-- lequel revêtement entoure la zone de raccordement (27, 29, 53) de la connexion (31, 33), et
-- lequel revêtement comprend le lieu de raccordement (41', 45', 49a, 49b) prévu pour la mise en contact de cette connexion (31, 33),
- une rainure (57, 59) prévue dans le corps de base (13), laquelle rainure entoure au moins partiellement, à l'extérieur, le lieu de raccordement (41', 45', 49a, 49b), de telle sorte à ce qu'elle crée une limitation dans l'espace lors d'un mouillage réalisé dans un processus de brasage tendre à l'aide d'une brasure tendre (61), et
- un élément de raccordement (55) brasé au niveau du lieu de raccordement (41', 45', 49a, 49b) au moyen de la brasure tendre (61) sur le revêtement (39', 43', 47), capteur pour lequel le lieu de raccordement (41', 45', 49a, 49b) se situe en dehors de la zone de raccordement (27, 29, 53) de la connexion (31, 33) correspondante, et est relié - par l'intermédiaire du revêtement (39', 43', 47) correspondant, qui comprend ce lieu de raccordement (41', 45', 49a, 49b) et entoure la zone de raccordement (27, 29, 53) correspondante - via une liaison électroconductrice avec la zone de raccordement (27, 29, 53) de la connexion (31, 33) correspondante,
et capteur pour lequel au moins les zones de la rainure (57, 59), qui sont revêtues avec le revêtement (39', 43', 47) correspondant, qui s'étendent dans des zones par l'intermédiaire desquelles la zone de raccordement (27, 29, 53) est reliée - via une liaison électroconductrice, par le biais du revêtement (39', 43', 47) respectif - avec le lieu de raccordement (41', 45', 49a, 49b) disposé à distance de celle-ci.

5. Capteur selon la revendication 4, pour lequel
- la connexion (31, 33) est une connexion à un blindage du capteur contre les perturbations électromagnétiques,
- le revêtement (47) fait partie intégrante du blindage, et
- le revêtement (47) forme la zone de raccordement de cette connexion.

6. Capteur selon la revendication 4 ou 5, avec au minimum une connexion électrique (31, 33) supplémentaire,
- laquelle connexion est acheminée dans une zone de raccordement (27, 29, 53) se trouvant sur une surface isolée extérieure du corps de base (13),
- connexion dont la zone de raccordement (27, 29, 53) est revêtue d'un revêtement (39', 43', 47) apte au brasage tendre, électroconducteur, appliqué sur la surface isolante extérieure du corps de base (13), lequel revêtement comprend le lieu de raccordement (41', 45', 49a, 49b) prévu pour la mise en contact de cette connexion (31, 33),
- connexion dont le lieu de raccordement (41', 45', 49a, 49b) est entouré, à l'extérieur, au moins partiellement par une rainure (57, 59) prévue dans le corps de base (13), et
- connexion sur le lieu de raccordement (41', 45', 49a, 49b) de laquelle un élément de raccordement (55) est brasé sur le revêtement (39', 43', 47) au moyen d'une jonction par brasage tendre (61), et
- connexion pour laquelle les différents revêtements (39', 43', 47) appliqués sur le corps de base (13) sont isolés électriquement les uns par rapport aux autres.

7. Capteur selon l'une des revendications 4 à 6,
avec une connexion électrique (31, 33),
-- laquelle connexion est acheminée dans une zone de raccordement (27, 29) se trouvant sur une surface isolante extérieure du corps de base (13),
- un revêtement (39, 43, 47) apte au brasage tendre, électroconducteur, appliqué sur la surface isolante extérieure du corps de base (13),
-- qui entoure la zone de raccordement (27, 29) de la connexion (31, 33), et
-- qui comprend un lieu de raccordement supplémentaire (41, 45) prévu pour la mise en contact de cette connexion (31, 33), lequel lieu de raccordement supplémentaire est disposé dans la zone de raccordement (27, 29) de la connexion (31, 33) correspondante, et
-- avec une rainure (57) prévue dans le corps de base (13), laquelle rainure entoure le lieu de raccordement supplémentaire (41, 45) au moins partiellement à l'extérieur, de telle sorte à ce qu'elle crée une limitation dans l'espace lors d'un mouillage réalisé dans un processus de brasage tendre à l'aide d'une brasure tendre (61), et un élément de raccordement (55) brasé sur le revêtement (39, 43, 47), au niveau du lieu de raccordement supplémentaire (41, 45), au moyen de la brasure tendre (61).

8. Capteur selon l'une des revendications 4 à 7, pour lequel au moins une rainure (57) entoure de tous côtés, notamment sous forme annulaire, le lieu de raccordement (41', 45', 49a) correspondant et/ou le lieu de raccordement supplémentaire (41, 45).

9. Capteur selon l'une des revendications 4 à 7, pour lequel au moins une rainure (59) présente une brisure ou une courbure, par l'intermédiaire de laquelle la position du lieu de raccordement (49b) est reconnaissable visuellement.

10. Capteur selon l'une des revendications 4 à 9, pour lequel
- le capteur est un capteur de pression capacitif avec une membrane de mesure (17) reliée avec le corps de base (13) en formant une chambre de mesure (15), et
- l'une des connexions (31) est une connexion à une électrode de mesure (21) appliquée sur le corps de base (13), et/ou
- l'une des connexions (33) est une connexion (33) à une électrode de référence (23, 23') appliquée sur le corps de base (13), et/ou
- l'une des connexions est une connexion acheminée à travers le corps de base (13) à une contre-électrode (25) appliquée sur la membrane de mesure (17).

11. Capteur selon la revendication 5 et 10, pour lequel le revêtement (47) de la zone de raccordement (53), dans laquelle la connexion reliée avec la contre-électrode (25) est acheminée, est en même temps le revêtement (47) du blindage, et le lieu de raccordement (49a, 49b) prévu pour la mise en contact de la connexion à la contre-électrode (25) est le lieu de raccordement (49a, 49b) prévu pour la mise en contact du blindage.

12. Capteur selon l'une des revendications 4 à 11, pour lequel
- le corps de base (13) est constitué d'une céramique, notamment une céramique d'oxyde d'aluminium, et/ou
- les revêtements (39, 39', 43, 43', 47) sont en or, en argent, en alliages de cuivre ou sont constitués de couches métalliques, notamment en nickel ou en alliages de nickel, lesquelles couches sont munies d'une couche de recouvrement apte au brasage tendre, ou sont constitués de vernis conducteur métallique, notamment un vernis conducteur de carbone ou d'argent, et/ou
- les jonctions de brasage tendre (61) sont constituées d'une brasure étain-argent, une brasure étain-cuivre ou une brasure contenant de l'indium et/ou du bismuth, notamment une brasure étain-argent contenant de l'indium et/ou du bismuth.
